# EUROPEAN PATENT APPLICATION

(11) **EP 4 542 640 A1**
(43) Date of publication of application: **23.04.2025**
(21) Application number: 23826429.5
(22) Date of filing: 20.06.2023
(51) Int. Cl.: H01L 23/367, H01L 23/473

(54) **LIQUID-COOLING PACKAGING STRUCTURE, LIQUID-COOLING HEAT DISSIPATION SYSTEM AND COMMUNICATION DEVICE**

(30) Priority: 23.06.2022 CN 202210719501
(71) Applicant: ZTE Corporation, Shenzhen, Guangdong 518057 (CN)
(72) Inventor: WU, Shengmei, Shenzhen, Guangdong 518057 (CN); WANG, Zhida, Shenzhen, Guangdong 518057 (CN); ZHANG, Xianming, Shenzhen, Guangdong 518057 (CN)
(74) Representative: Savi, Massimiliano
(86) International application number: PCT/CN2023/101412
(87) International publication number: WO 2023/246782

(57) **Abstract**

Disclosed in the present application are a liquid-cooling packaging structure, a liquid-cooling heat dissipation system and a communication device. The liquid-cooling packaging structure (100) comprises a sealing cavity (200) and a flow disturbing block (600), wherein the sealing cavity (200) comprises at least one integrated chip; the sealing cavity (200) is provided with a liquid intake interface (300) and a liquid output interface (400); a heat dissipation fin (500) is arranged on an inner side of the integrated chip; the flow disturbing block (600) is arranged inside the sealing cavity (200); and a liquid cooling flow channel (700), a liquid in which flows to the liquid output interface (400), is formed between the integrated chip and the flow disturbing block (600).

## Description

### CROSS-REFERENCE TO RELATED APPLICATION

This application is based on and claims the priority of Chinese patent application No. 202210719501.X filed on June 23, 2022, the disclosure of which is incorporated herein by reference in its entirety.

### TECHNICAL FIELD

The present disclosure relates to the technical field of heat dissipation, and in particular to a liquid-cooling package structure, a liquid-cooling heat dissipation system, and a communication device.

### BACKGROUND

With the rapid development of the new generation of information and communication technologies represented by the fifth generation of mobile communication technology, artificial intelligence, cloud computing, and blockchain, the related core electronic devices such as central processing units, graphics processing units, and application-specific integrated circuits, will strive for higher computing speeds and a high degree of integration. High computing speeds require high-density transistor carriers, and highly integrated packaged chips are prone to significantly increased power density per unit volume due to stacked packaging, so the heat flux density of future chips will reach a higher level. In response to the heat dissipation needs of chips under high heat flux density, the relevant heat dissipation schemes have gradually shifted from air-cooling heat dissipation to liquid-cooling heat dissipation. For the use of liquid-cooling heat dissipation, it is necessary to make the workpiece closer to the heat source in order to reduce thermal resistance. The liquid-cooling schemes in the related technology have also shifted from the outside of chips to the inside of chips. However, due to space constraints, the liquid-cooling flow channels inside the chips have become fine, which leads to larger flow resistance and reduces the efficiency of heat dissipation.

### SUMMARY

The present disclosure provides a liquid-cooling package structure, a liquid-cooling heat dissipation system, and a communication device.

In accordance with a first aspect of the present disclosure, an embodiment provides a liquid-cooling package structure including a sealed cavity and a turbulence block. The sealed cavity includes at least one integrated chip and is provided with a liquid inlet port and a liquid outlet port, and an inner side of the integrated chip is provided with heat dissipation fins. The turbulence block is provided within the sealed cavity, and a liquid-cooling flow channel directed toward the liquid outlet port is formed between the integrated chip and the turbulence block.

In accordance with a second aspect of the present disclosure, an embodiment provides a liquid-cooling heat dissipation system including the liquid-cooling package structure according to the embodiment of the first aspect of the present disclosure and a liquid heat exchange device. The liquid-cooling package structure is connected to the liquid heat exchange device, and the liquid heat exchange device is connected to the liquid inlet port and the liquid outlet port.

In accordance with a third aspect of the present disclosure, an embodiment provides a communication device including the liquid-cooling package structure according to the embodiment of the first aspect of the present disclosure or the liquid-cooling heat dissipation system according to the embodiment of the second aspect of the present disclosure.

### BRIEF DESCRIPTION OF DRAWINGS

FIG. 1 is an exploded schematic diagram of a liquid-cooling package structure according to an embodiment of the present disclosure;
FIG. 2 is a schematic diagram of a liquid-cooling package structure according to another embodiment of the present disclosure;
FIG. 3 is a partial schematic diagram of a liquid-cooling package structure according to another embodiment of the present disclosure;
FIG. 4 is a schematic cross-sectional view of a liquid-cooling package structure according to another embodiment of the present disclosure;
FIG. 5 is a schematic diagram of an integrated chip provided with heat dissipation fins according to an embodiment of the present disclosure;
FIG. 6 is a schematic diagram of a liquid-cooling package structure according to another embodiment of the present disclosure;
FIG. 7 is a schematic diagram of a turbulence block according to an embodiment of the present disclosure;
FIG. 8 is a schematic diagram of a turbulence block according to another embodiment of the present disclosure;
FIG. 9 is a schematic diagram of a liquid-cooling package structure according to another embodiment of the present disclosure;
FIG. 10 is a schematic diagram of a liquid-cooling package structure according to another embodiment of the present disclosure;
FIG. 11 is a schematic diagram of a turbulence block according to another embodiment of the present disclosure;
FIG. 12 is a schematic diagram of a turbulence block according to another embodiment of the present disclosure;
FIG. 13 is a schematic diagram of a liquid-cooling package structure according to another embodiment of the present disclosure;
FIG. 14 is a partial schematic diagram of a liquid-cooling package structure according to another embodiment of the present disclosure; and
FIG. 15 is a schematic diagram of a liquid-cooling heat dissipation system according to an embodiment of the present disclosure.

### DETAILED DESCRIPTION

This section will describe embodiments of the present disclosure in detail, and preferable embodiments of the present disclosure are shown in the accompanying drawings. The accompanying drawings are used to supplement the text description of the specification with graphic illustrations, so that each technical feature and the overall technical scheme of the present disclosure can be intuitively and vividly understood. However, the accompanying drawings should not be construed as limiting the scope of protection of the present disclosure.

In the description of the present disclosure, the meaning of "several" is one or more; the meaning of "a plurality of" is two or more; "greater than", "less than", "more than", etc. are to be construed as excluding a given figure; and "above", "below", "within", etc. are to be construed as including a given figure. If "first" and "second", etc. are referred to, it is only for the purpose of distinguishing technical features, and shall not be construed as indicating or implying relative importance or implying the number of the indicated technical features or implying the sequence of the indicated technical features.

In the description of the present disclosure, unless otherwise explicitly defined, the terms such as "arrange", "install", and "connect" should be construed in a broad sense, and those having ordinary skills in the art can determine the specific meanings of the above terms in the present disclosure in a rational way in conjunction with the specific contents of the technical schemes.

The current heat dissipation schemes have gradually shifted from air-cooling heat dissipation to liquid-cooling heat dissipation. For the use of liquid-cooling heat dissipation, thermal resistance and flow resistance are the key indicators, and it is necessary to make the workpiece closer to the heat source in order to reduce the thermal resistance. The liquid-cooling schemes in the related technology have also shifted from the outside of chips to the inside of chips. However, due to space constraints, the liquid-cooling flow channels inside the chips have become fine, which leads to larger flow resistance and reduces the efficiency of heat dissipation, thus failing to effectively solve the problem of heat dissipation in the case of high heat flux density.

Embodiments of the present disclosure provide a liquid-cooling package structure, a liquid-cooling heat dissipation system, and a communication device, which can lead to uniform surface temperature of an integrated chip and low flow resistance, thereby contributing to the improvement of the efficiency of heat dissipation.

The embodiments of the present disclosure will be described below with reference to the accompanying drawings.

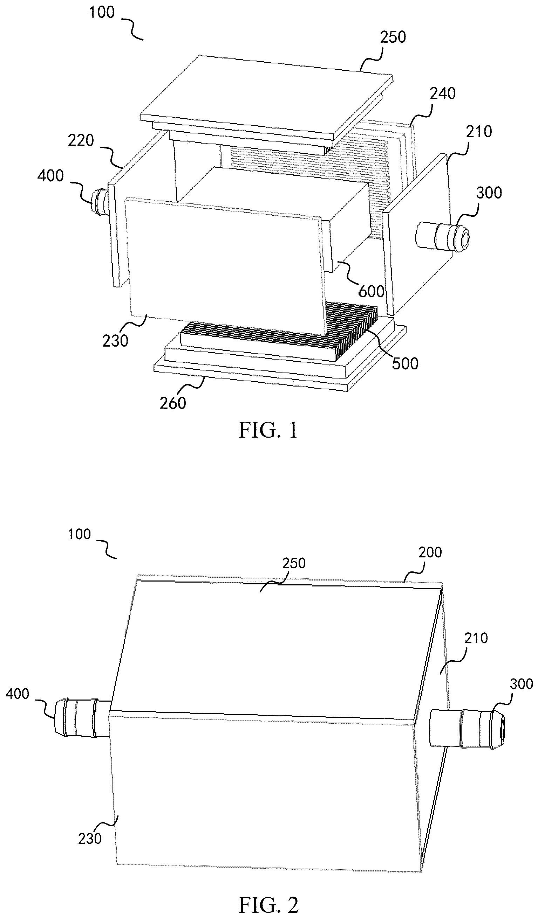

As shown in FIGS. 1-4, an embodiment of a first aspect of the present disclosure provides a liquid-cooling package structure 100 including a sealed cavity 200 and a turbulence block 600, the sealed cavity 200 including at least one integrated chip. The sealed cavity 200 is provided with a liquid inlet port 300 and a liquid outlet port 400, and an inner side of the integrated chip is provided with heat dissipation fins 500. The turbulence block 600 is provided within the sealed cavity 200. A liquid-cooling flow channel 700 directed toward the liquid outlet port 400 is formed between the integrated chip and the turbulence block 600.

In the liquid-cooling package structure 100 of the present disclosure, by providing the sealed cavity 200, the transistor density can be increased so as to satisfy the demand for high-density carriers. The sealed cavity 200 includes at least one integrated chip, and the cooling liquid can enter the sealed cavity 200 through the liquid inlet port 300. By providing the turbulence block 600 within the sealed cavity 200, the cooling liquid can flow through an effective heat dissipation region in which the cooling liquid exchanges heat with the integrated chip, which can lead to uniform surface temperature of the integrated chip. By providing the heat dissipation fins 500 on the inner side of the integrated chip, the heat exchange area can be increased and the heat dissipation thermal resistance can be reduced. The liquid-cooling flow channel 700 can be formed between the integrated chip and the turbulence block 600, so that the cooling liquid exchanges heat with the integrated chip and then flows to the liquid outlet port 400, which results in low flow resistance and facilitates improvement of the efficiency of heat dissipation, thus solving the heat dissipation problem of chips with high heat flux density and high power consumption.

It can be understood that the integrated chip may be provided on a side face of the sealed cavity 200, and the number of the integrated chips may be one or more. If the sealed cavity 200 includes one integrated chip, the integrated chip may be placed on the upper side face of the sealed cavity 200. By providing the turbulence block 600 within the sealed cavity 200, the cooling liquid can flow through the effective heat dissipation cross-section of the integrated chip, so as to meet the heat dissipation demand of the chip with high heat flux density. If the sealed cavity 200 includes a plurality of integrated chips, different integrated chips can use the same liquid-cooling flow channel 700 without having to machine sealed flow channels for individual integrated chips, which can effectively reduce the flow resistance.

According to an embodiment of the present disclosure, the liquid inlet port 300 and the liquid outlet port 400 may be used for connecting the sealed cavity 200 with the external liquid heat exchange device, so that the liquid-cooling package structure 100 can be continuously cooled by heat exchange, thereby ensuring that the integrated chip can work normally.

The integrated chips may each be integrated by means of 2D integration, 2D+ integration, 2.5D integration, 3D integration, or other manners, and the plurality of integrated chips may be connected to each other by means of flexible or rigid connections, thereby constituting the outer side faces of the liquid-cooling flow channel 700, which enables effective expansion of the space of the liquid-cooling flow channel 700 and ensures heat dissipation while effectively reducing the flow resistance. By providing the sealed cavity 200, the transistor density can be increased to achieve good packaging of electronic devices and meet the high-computing use requirements. Meanwhile, the heat exchange area can be expanded. By adopting the liquid-cooling heat dissipation method, the problem of difficult heat dissipation inside the highly integrated chips can be solved, thus meeting the heat dissipation requirements of the integrated chips under high heat flux density.

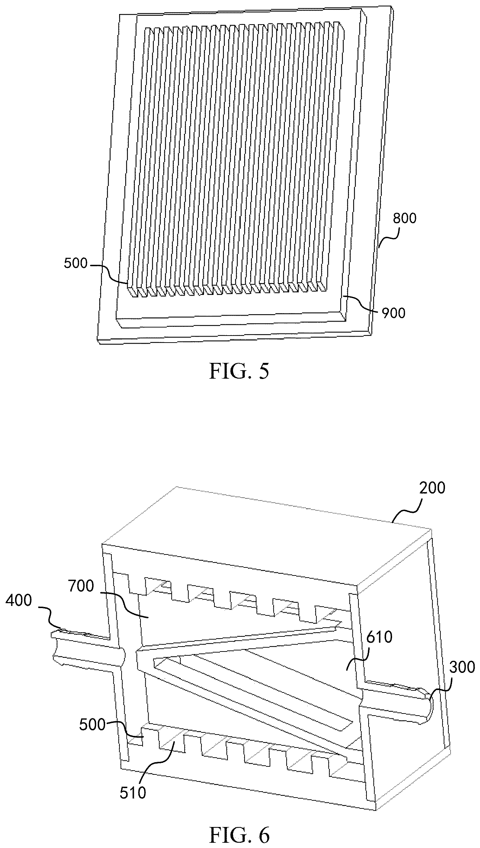

As shown in FIG. 5, according to an embodiment of the present disclosure, a plurality of heat dissipation fins 500 are provided on the integrated chip, and the plurality of heat dissipation fins 500 are arranged parallel to each other at equal intervals. The spacing between adjacent heat dissipation fins 500 may be set according to actual needs.

In the liquid-cooling package structure 100 described above, the heat dissipation fins 500 are in the shape of plates, columns, or triangles.

It can be understood that, depending on different application scenarios, different shapes of heat dissipation fins 500 may be selected, and the heat dissipation fins 500 may be in the shape of plates, columns, or triangles, and the shapes of the plurality of heat dissipation fins 500 may be the same or different, and suitable heat dissipation fins 500 are selected based on the simulation and the machining optimization topology design.

According to an embodiment of the present disclosure, the heat dissipation fins 500 may be made of silicon or silicon carbide and therefore have good heat dissipation performance.

As shown in FIG. 5, in the liquid-cooling package structure 100 described above, the integrated chip includes a substrate 800 and a die 900 provided on the substrate 800, the heat dissipation fins 500 are provided on the die 900.

The integrated chip includes the substrate 800 and the die 900, and the heat dissipation fins 500 may be etched or bonded on a surface layer of the die 900. By providing the heat dissipation fins 500 on the integrated chip, the heat exchange area can be increased, and the heat transfer distance can be shortened, thereby reducing the thermal resistance.

Due to the formation of the liquid-cooling flow channel 700 between the integrated chip and the turbulence block 600, the turbulence block 600 can make the flow of the cooling liquid more uniform, thereby making the effect of heat dissipation of the integrated chip better and effectively reducing the operating temperature of the integrated chip.

As shown in FIGS. 1 and 2, in the liquid-cooling package structure 100 described above, the sealed cavity 200 includes a first integrated chip 210 and a second integrated chip 220 arranged oppositely, the liquid inlet port 300 is provided on the first integrated chip 210 and the liquid outlet port 400 is provided on the second integrated chip 220.

The first integrated chip 210 and the second integrated chip 220 are provided oppositely, and by providing the liquid inlet port 300 on the first integrated chip 210 and the liquid outlet port 400 on the second integrated chip 220, the liquid inlet port 300 and the liquid outlet port 400 are arranged oppositely, which facilitates guiding the directional flow of the cooling liquid, thereby greatly reducing the flow resistance and enhancing the heat dissipation capability of the liquid-cooling package structure 100.

As shown in FIG. 1, in the liquid-cooling package structure 100 described above, the sealed cavity 200 further includes a third integrated chip 230, a fourth integrated chip 240, a fifth integrated chip 250, and a sixth integrated chip 260. The third integrated chip 230 is arranged opposite to the fourth integrated chip 240, and the fifth integrated chip 250 is arranged opposite to the sixth integrated chip 260. The first integrated chip 210 is connected to the third integrated chip 230, the fourth integrated chip 240, the fifth integrated chip 250, and the sixth integrated chip 260. The second integrated chip 220 is connected to the third integrated chip 230, the fourth integrated chip 240, the fifth integrated chip 250, and the sixth integrated chip 260. The third integrated chip 230 is connected to the fifth integrated chip 250 and the sixth integrated chip 260. The fourth integrated chip 240 is connected to the fifth integrated chip 250 and the sixth integrated chip 260.

As shown in FIG. 1, it can be understood that the sealed cavity 200 according to the present disclosure is formed by interconnection of a plurality of integrated chips. In some embodiments, the sealed cavity 200 is formed by interconnection of the first integrated chip 210, the second integrated chip 220, the third integrated chip 230, the fourth integrated chip 240, the fifth integrated chip 250, and the sixth integrated chip 260, and the liquid-cooling flow channel 700 is formed between the plurality of integrated chips and the turbulence block 600. In contrast to a structure in which a plurality of integrated chips are stacked in parallel, the liquid-cooling package structure 100 according to the present disclosure does not require the machining of sealed flow channels on single integrated chips. This can effectively solve the problem of complex flow channel process in the stacking scenario, and the cross-scale liquid-cooling flow channel can ensure a good effect of heat dissipation while greatly reducing the flow resistance.

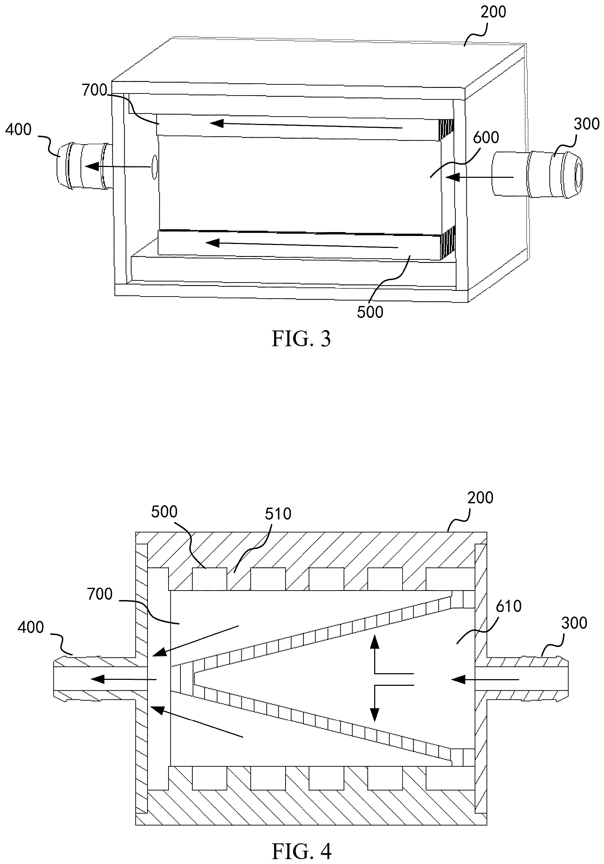

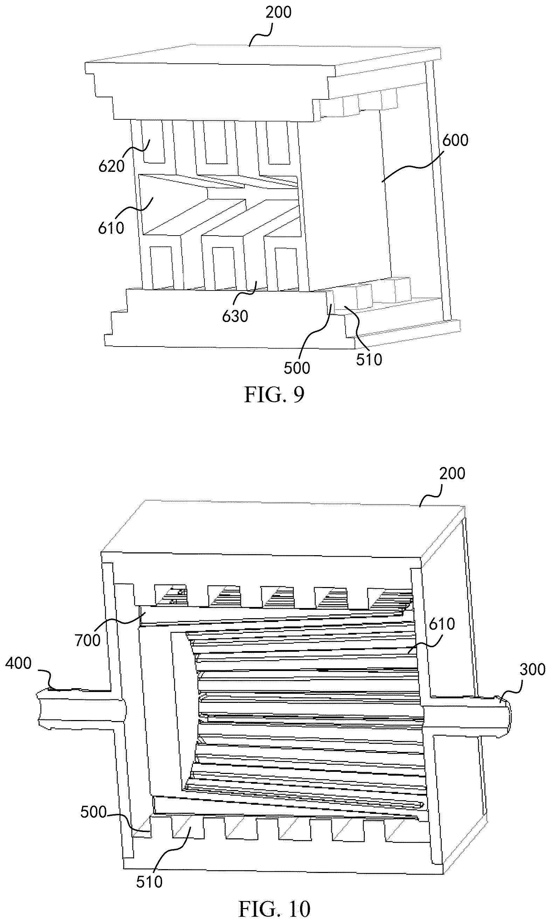

As shown in FIGS. 4 and 6 to 12, in the liquid-cooling package structure 100 described above, the turbulence block 600 is provided with an internal cavity 610 in communication with the liquid inlet port 300, and a peripheral side of the turbulence block 600 is provided with slot channels 620 recessed inward to form the liquid-cooling flow channel 700, the internal cavity 610 is in communication with the liquid-cooling flow channel 700.

The turbulence block 600 is further provided with communication slots 630, and the cooling liquid enters the internal cavity 610 of the turbulence block 600 through the liquid inlet port 300, and passes through the communication slots 630 to flow to heat dissipation channels 510 between the heat dissipation fins 500. After heat exchange with the integrated chip, the cooling liquid flows to slot channels 620 at the peripheral side of the turbulence block 600, i.e., to the liquid-cooling flow channel 700, so that the cooling liquid flows through an effective heat dissipation region, thereby greatly improving the efficiency of heat dissipation.

As shown in FIGS. 4 and 6 to 12, in the liquid-cooling package structure 100 described above, a cross-section of the liquid-cooling flow channel 700 gradually increases in a direction from the liquid inlet port 300 to the liquid outlet port 400.

In this embodiment, the turbulence block 600 is of a variable-diameter jet structure, and the depth of the slot channels 620 gradually increases in the direction from the liquid inlet port 300 to the liquid outlet port 400, i.e., the cross-section of the liquid-cooling flow channel 700 gradually increases in the direction from the liquid inlet port 300 to the liquid outlet port 400. Accordingly, the internal cavity 610 of the turbulence block 600 is a variable-diameter cavity. It can be understood that the liquid-cooling flow channel 700 is a flow channel with variable cross-section and the cooling liquid enters from the inlet end of the internal cavity 610, passes through the communication slots 630 and flows into the liquid-cooling flow channel 700, and the cooling liquid is ejected out toward the liquid outlet port 400 as the cross-section of the liquid-cooling flow channel 700 changes. This can reduce the length of the high-speed flow channel and reduce the flow resistance, and thus can effectively lead to uniform surface temperature of the integrated chip and improve the reliability of the use of the liquid-cooling package structure 100. Moreover, the high-speed jet breaks the thermal boundary layer, which can effectively improve the heat dissipation capability.

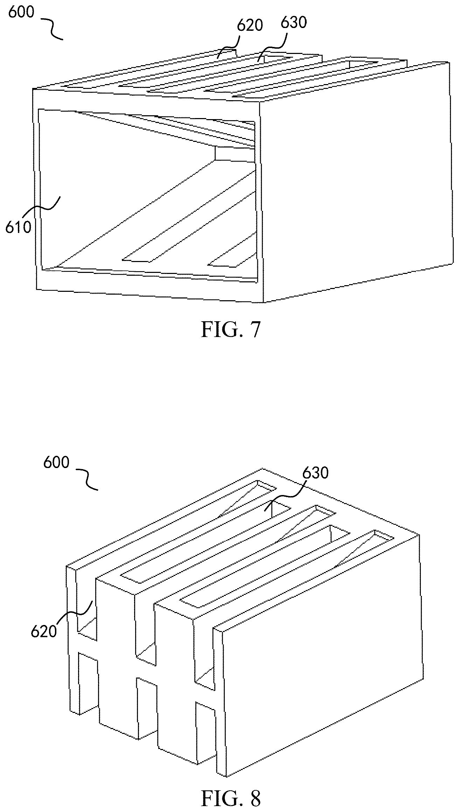

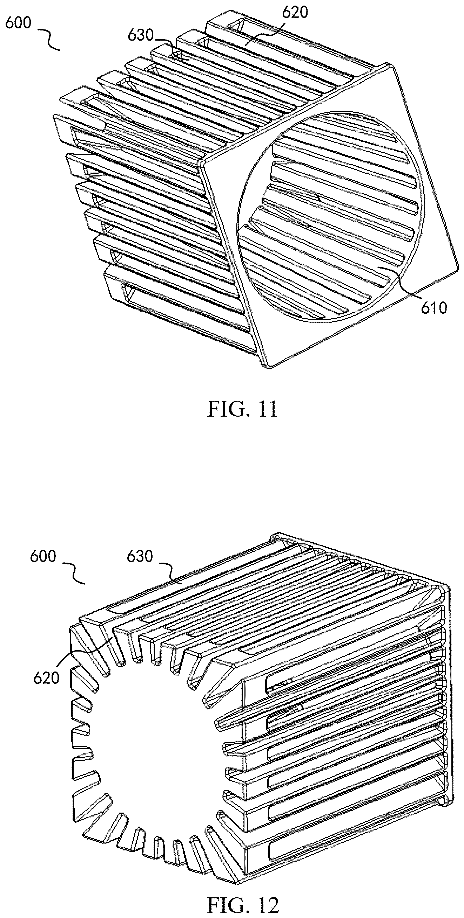

As shown in FIGS. 7, 8, 11, and 12, according to an embodiment of the present disclosure, the turbulence block 600 may be in the shape of a wedge, a dome, or a cone, which facilitates the formation of a flow channel with variable cross-section. FIGS. 7 and 8 illustrate a wedge-shaped turbulence block 600, and FIGS. 11 and 12 illustrate a dome-shaped turbulence block 600. The liquid-cooling package structure 100 of the present disclosure is suitable for use in application scenarios at high heat flux density to satisfy heat dissipation requirements.

As shown in FIGS. 4 and 6 to 9, in the liquid-cooling package structure 100 described above, a length direction of the heat dissipation fins 500 adjacent to the peripheral side of the turbulence block 600 is perpendicular to an extension direction of the liquid-cooling flow channel 700, and a heat dissipation channel 510 is formed between two adjacent ones of the heat dissipation fins 500, the heat dissipation channel 510 is perpendicular to the liquid-cooling flow channel 700.

In this embodiment, the heat dissipation fins 500 are plate-like. By making the length direction of the heat dissipation fins 500 adjacent to the peripheral side of the turbulence block 600 perpendicular to the extension direction of the liquid-cooling flow channel 700, the heat dissipation channel 510 is perpendicular to the liquid-cooling flow channel 700. Such a perpendicular structure is finely dimensioned to improve the heat exchange capacity. After the cooling liquid flows into the internal cavity 610 of the turbulence block 600 through the liquid inlet port 300, it gradually fills the communication slots 630 and flows toward the surface of the heat dissipation fins 500. The cooling liquid flows along the heat dissipation channels 510 and continuously exchanges heat with the heat generated by the integrated chip, and then flows to the liquid-cooling flow channel 700 and finally toward the liquid outlet port 400 and flows out to take away the heat of the integrated chip, so as to realize a good effect of heat dissipation.

By making the length direction of the heat dissipation fins 500 perpendicular to the extension direction of the liquid-cooling flow channel 700, the plurality of heat dissipation fins 500 are arranged in a direction parallel to the extension direction of the liquid-cooling flow channel 700, so that the cooling liquid can flow sufficiently to the effective heat dissipation cross-section of the integrated chip and the cooling liquid can flow in a directional manner along the direction of the heat dissipation channels 510, thereby enabling uniform surface temperature of the integrated chip.

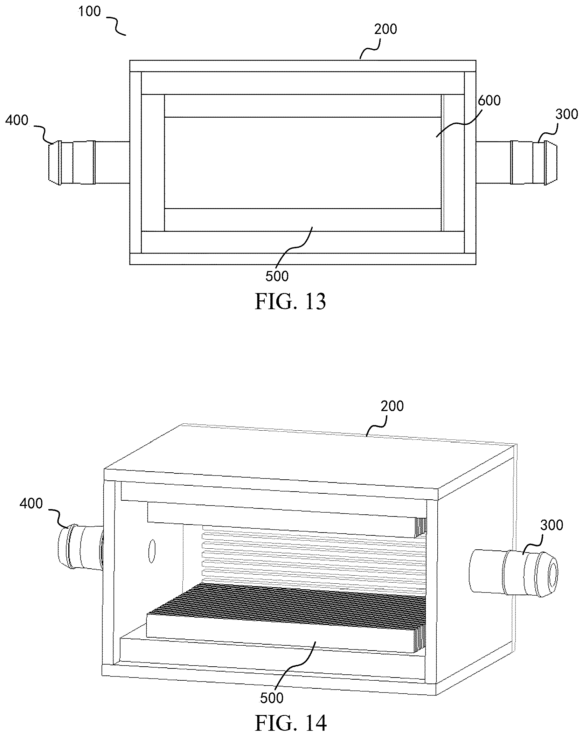

As shown in FIGS. 1, 3, 13, and 14, in the liquid-cooling package structure 100 described above, the turbulence block 600 is a right prism or a cylinder, so that the liquid-cooling flow channel 700 formed between a peripheral side of the turbulence block 600 and the integrated chip is a flow channel with constant cross-section.

In this embodiment, the turbulence block 600 is of a parallel flow structure, and the turbulence block 600 may be a right prism or a cylinder, so that the liquid-cooling flow channel 700 formed between the peripheral side of the turbulence block 600 and the integrated chip is a flow channel with constant cross-section, which enables the cooling liquid to flow to the effective heat dissipation cross-section of the integrated chip, so as to ensure good heat dissipation while simplifying the structure of the turbulence block 600, thus making feasibility and reliability higher. It can be understood that the cooling liquid enters the sealed cavity 200 through the liquid inlet port 300 and flows in parallel to the liquid outlet port 400 along the peripheral side of the turbulence block 600, which is suitable for application scenarios in which dimensional space is allowed and the heat flux density is relatively low. In some embodiments, the turbulence block 600 may be rectangular or square and the integrated chip is provided on an upper side face or a lower side face of the sealed cavity 200. The turbulence block 600 illustrated in FIGS. 1, 3, and 13 is rectangular.

As shown in FIGS. 3, 13, and 14, according to an embodiment of the present disclosure, the length direction of the heat dissipation fins 500 adjacent to the peripheral side of the turbulence block 600 is parallel to the length direction of the turbulence block 600, and by adaptively increasing the height of the heat dissipation fins 500, the space of the liquid-cooling flow channel 700 can be enlarged and the heat dissipation area can be increased. After the cooling liquid enters the sealed cavity 200, it can flow in parallel to the liquid outlet port 400 along the length direction of the heat dissipation fins 500, and the heat dissipation fins 500 enable the cooling liquid to flow in a directional manner, thereby ensuring a good effect of heat dissipation and making the structure of the turbulence block 600 simple. In some embodiments, the liquid-cooling flow channel 700 may be on a millimeter scale.

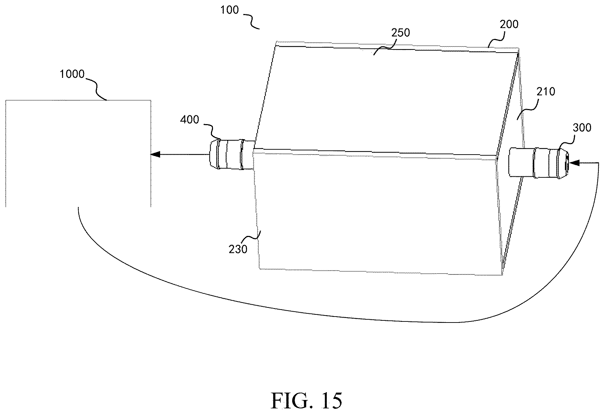

As shown in FIGS. 1 to 4 and 15, an embodiment of a second aspect of the present disclosure provides a liquid-cooling heat dissipation system including the liquid-cooling package structure 100 according to the embodiment of the first aspect of the present disclosure and a liquid heat exchange device 1000, where the liquid-cooling package structure 100 is connected to the liquid heat exchange device 1000, and the liquid heat exchange device 1000 is connected to the liquid inlet port 300 and the liquid outlet port 400.

In the liquid-cooling heat dissipation system of the present disclosure, the liquid-cooling package structure 100 and the liquid heat exchange device are included. The liquid heat exchange device is connected to the liquid inlet port 300 to input the cooling liquid into the liquid-cooling package structure 100 and the liquid heat exchange device 1000 is connected to the liquid outlet port 400 to recycle the liquid output from the liquid-cooling package structure 100, facilitating the realization of the circulating heat exchange. The liquid-cooling package structure 100 includes the sealed cavity 200 and the turbulence block 600. By providing the sealed cavity 200, the transistor density can be increased so as to satisfy the demand for high-density carriers. The sealed cavity 200 includes at least one integrated chip, and the cooling liquid can enter the sealed cavity 200 through the liquid inlet port 300. By providing the turbulence block 600 within the sealed cavity 200, the cooling liquid can flow through an effective heat dissipation region in which the cooling liquid exchanges heat with the integrated chip, which can lead to uniform surface temperature of the integrated chip. By providing the heat dissipation fins 500 on the inner side of the integrated chip, the heat exchange area can be increased and the heat dissipation thermal resistance can be reduced. The liquid-cooling flow channel 700 can be formed between the integrated chip and the turbulence block 600, so that the cooling liquid exchanges heat with the integrated chip and then flows to the liquid outlet port 400, which results in low flow resistance and facilitates improvement of the efficiency of heat dissipation, thus solving the heat dissipation problem of chips with high heat flux density and high power consumption.

According to an embodiment of the present disclosure, the flow rate and volume of the cooling liquid are set according to the heat flux density of the integrated chip. For example, in a scenario of high heat flux density, a higher efficiency of heat dissipation can be achieved by increasing the flow rate and volume of the cooling liquid that is input to the liquid-cooling package structure 100 by the liquid heat exchange device 1000, thereby facilitating optimization of flow resistance.

It can be understood that the low-temperature cooling liquid is input by the liquid heat exchange device 1000 to the liquid-cooling package structure 100 via the liquid inlet port 300 and liquid-cooling heat dissipation of the integrated chip is realized through heat exchange with the integrated chip. The heated cooling liquid flows to the liquid-cooling flow channel 700 formed between the integrated chip and the turbulence block 600, and finally flows back to the liquid heat exchange device 1000 via the liquid outlet port 400. The high-temperature cooling liquid is cooled by the liquid heat exchange device 1000, and the low-temperature cooling liquid is again input into the liquid-cooling package structure 100 via the liquid inlet port 300. Such cycle ensures that the liquid-cooling package structure 100 can continuously carry out heat exchange to satisfy the heat dissipation needs of the integrated chip with high heat flux density, so that the integrated chip can be maintained in a normal operating temperature range.

An embodiment of a third aspect of the present disclosure provides a communication device including the liquid-cooling package structure 100 according to the embodiment of the first aspect of the present disclosure or the liquid-cooling heat dissipation system according to the embodiment of the second aspect of the present disclosure.

In the communication device of the present disclosure, the liquid-cooling package structure 100 is arranged, which includes the sealed cavity 200 and the turbulence block 600. By providing the sealed cavity 200, the transistor density can be increased so as to satisfy the demand for high-density carriers. The sealed cavity 200 includes at least one integrated chip, and the cooling liquid can enter the sealed cavity 200 through the liquid inlet port 300. By providing the turbulence block 600 within the sealed cavity 200, the cooling liquid can flow through an effective heat dissipation region in which the cooling liquid exchanges heat with the integrated chip, which can lead to uniform surface temperature of the integrated chip. By providing the heat dissipation fins 500 on the inner side of the integrated chip, the heat exchange area can be increased and the heat dissipation thermal resistance can be reduced. The liquid-cooling flow channel 700 can be formed between the integrated chip and the turbulence block 600, so that the cooling liquid exchanges heat with the integrated chip and then flows to the liquid outlet port 400, which results in low flow resistance and facilitates improvement of the efficiency of heat dissipation, thus solving the heat dissipation problem of chips with high heat flux density and high power consumption, thereby ensuring that the communication device can work stably and efficiently.

According to an embodiment of the present disclosure, the communication device may be a communication product such as a building base band unit (BBU) device, an active antenna unit (AAU) device, a server, a switch, and the like.

## Claims

1. A liquid-cooling package structure, comprising:
a sealed cavity, wherein the sealed cavity comprises at least one integrated chip and is provided with a liquid inlet port and a liquid outlet port, and an inner side of the integrated chip is provided with heat dissipation fins; and
a turbulence block, wherein the turbulence block is provided within the sealed cavity, a liquid-cooling flow channel directed toward the liquid outlet port is formed between the integrated chip and the turbulence block.

2. The liquid-cooling package structure of claim 1, wherein the integrated chip comprises a substrate and a die provided on the substrate, the heat dissipation fins are provided on the die.

3. The liquid-cooling package structure of claim 1, wherein the sealed cavity comprises a first integrated chip and a second integrated chip arranged oppositely, the liquid inlet port is provided on the first integrated chip and the liquid outlet port is provided on the second integrated chip.

4. The liquid-cooling package structure of claim 3, wherein the sealed cavity further comprises a third integrated chip, a fourth integrated chip, a fifth integrated chip, and a sixth integrated chip;
the third integrated chip is arranged opposite to the fourth integrated chip, and the fifth integrated chip is arranged opposite to the sixth integrated chip,
the first integrated chip is connected to the third integrated chip, the fourth integrated chip, the fifth integrated chip, and the sixth integrated chip, and the second integrated chip is connected to the third integrated chip, the fourth integrated chip, the fifth integrated chip, and the sixth integrated chip, and
the third integrated chip is connected to the fifth integrated chip and the sixth integrated chip, and the fourth integrated chip is connected to the fifth integrated chip and the sixth integrated chip.

5. The liquid-cooling package structure of claim 1, where the turbulence block is provided with an internal cavity in communication with the liquid inlet port, and a peripheral side of the turbulence block is provided with slot channels recessed inward to form the liquid-cooling flow channel, the internal cavity is in communication with the liquid-cooling flow channel.

6. The liquid-cooling package structure of claim 5, wherein a cross-section of the liquid-cooling flow channel gradually increases in a direction from the liquid inlet port to the liquid outlet port.

7. The liquid-cooling package structure of claim 5, wherein a length direction of the heat dissipation fins adjacent to the peripheral side of the turbulence block is perpendicular to an extension direction of the liquid-cooling flow channel, and a heat dissipation channel is formed between two adjacent ones of the heat dissipation fins, the heat dissipation channel is perpendicular to the liquid-cooling flow channel.

8. The liquid-cooling package structure of claim 1, wherein the turbulence block is a right prism or a cylinder, so that the liquid-cooling flow channel formed between a peripheral side of the turbulence block and the integrated chip is a flow channel with constant cross-section.

9. The liquid-cooling package structure of claim 1, wherein the heat dissipation fins are in the shape of plates, columns, or triangles.

10. A liquid-cooling heat dissipation system comprising the liquid-cooling package structure of any one of claims 1 to 9 and a liquid heat exchange device, wherein the liquid-cooling package structure is connected to the liquid heat exchange device, and the liquid heat exchange device is connected to the liquid inlet port and the liquid outlet port.

11. A communication device comprising the liquid-cooling package structure of any one of claims 1 to 9 or comprising the liquid-cooling heat dissipation system of claim 10.
